# EUROPEAN PATENT APPLICATION

(11) **EP 1 215 780 A2**
(43) Date of publication of application: **19.06.2002**
(21) Application number: 01127388.5
(22) Date of filing: 22.11.2001
(51) Int. Cl.: H01S 5/223

(54) **Semiconductor optical device**

(30) Priority: 22.11.2000 JP 2000356423
(71) Applicant: Kabushiki Kaisha Toshiba, Tokyo (JP)
(72) Inventor: Matsuyama, Takayuki, Minato-ku, Tokyo (JP)
(74) Representative: HOFFMANN - EITLE

(57) **Abstract**

A semiconductor optical device has a ridge of a laser device having a mesa shape, or has a mesa portion of an LED, each obtained by forming a groove in a semiconductor substrate. The groove is filled with a resin containing benzocyclobutene. Since the resin is buried in the groove to reliably and easily planarize its surface, it is possible to improve the flatness of the surface of the device, and reduce the dielectric constant and the water absorbance. This makes it possible to provide a high-performance, high-reliability semiconductor optical device.

## Description

### BACKGROUND OF THE INVENTION

The present invention relates to a semiconductor optical device.

Some optical devices, e.g., a light emitting device such as a laser device or a light emitting diode, a light receiving device such as a light emitting diode, and an optical modulator such as a laser device, are provided with a portion having a function of constricting an electric current into an active layer formed on the surface of a semiconductor substrate, or a portion having a mesa shape including an active layer.

A portion having a mesa shape can be formed into any arbitrary shape, e.g., a substantially stripe "ridge" shape or a substantially circular shape, in accordance with its structure and intended use. The sectional shape of the mesa can also be a so-called "normal mesa" or an "inverted mesa".

As an example of a semiconductor optical device having this mesa portion, an outline of the arrangement and problems of a ridge type semiconductor laser will be explained below. The problems explained below similarly exist in a light receiving device and an optical modulator as well as in a light emitting device such as a light emitting diode.

A ridge type semiconductor laser device has a structure by which the parasitic capacitance can be decreased, and this makes high-speed modulation possible. Therefore, this ridge type semiconductor laser device is expected to be applied as a key device of a large-capacity optical communication system. In particular, a ridge type waveguide semiconductor laser (RWG-LD) has a structure suited to high-speed, high-output operations.

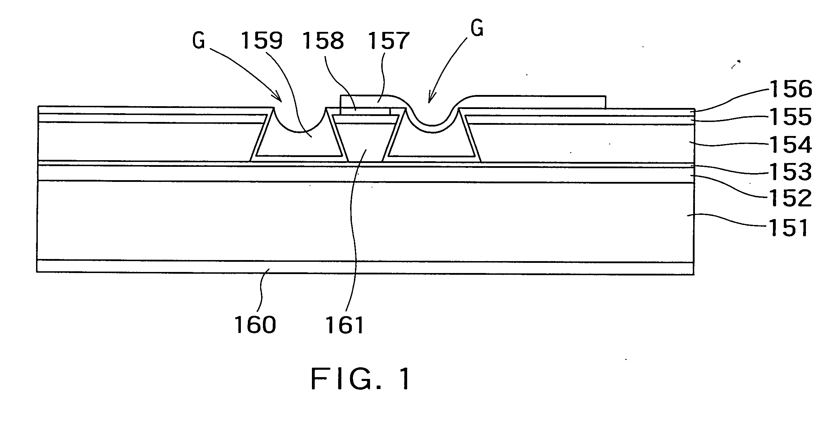

Fig. 1 is a conceptual view showing the structure of a Fabry-Perot RWG-LD related to the present invention. That is, Fig. 1 shows a sectional structure in a direction perpendicular to the direction of laser resonance.

One characteristic feature of this structure is that grooves G for defining a ridge 161 are filled with a polyimide resin 159. The arrangement of this laser will be described below following the procedure of fabrication.

First, on an n-type InP substrate 151, an n-type InP cladding layer 152 (thickness 2 µm, S-doped, 1 x 10¹⁸ cm⁻³), a 1.3-µm composition MQW active layer 153, a p-type InP cladding layer 154 (thickness 2 µm, Zn-doped, carrier concentration 1 x 10¹⁸ cm⁻³), and a p-type InGaAs contact layer 155 (thickness 0.3 µm, Zn-doped, carrier concentration 8 x 10¹⁸ cm⁻³) are sequentially formed by crystal growth by MOCVD (Metal-Oxide Chemical Vapor Deposition).

Next, an SiO₂ film 156 is formed on the entire wafer surface, two stripe windows 5 µm wide are formed on the wafer by photolithography, and the SiO₂ film 156 is etched away into the form of stripes. subsequently, the p-type InGaAs contact layer 155 and the p-type InP cladding layer 154 are etched away in this order by a sulfuric acid-based etchant and a hydrogen bromide-based etchant. This etching stops immediately above the 1.3-µm composition MQW active layer 153, forming an inverted-mesa-shaped ridge 161 defined by grooves G.

An SiO₂ film 156 is formed on the entire wafer surface and coated with a polyimide resin 159. After this polyimide resin 159 is cured at 350°C, the top of the ridge is exposed by reactive ion etching (RIE). By this operation, the polyimide resin 159 can be buried in the grooves at the two sides of the ridge. Then, a stripe window 3 µm wide is formed on the ridge 161. A p-type electrode AuZn 158 is deposited on the entire wafer surface and processed to leave stripe AuZn in the window by liftoff. The resist is removed, the resultant structure is sintered at 450°C, and a bonding pad 157 made of a Ti/Pt/Au electrode is formed by deposition and liftoff.

Next, the n-type InP substrate 151 is polished to a thickness of 100 µm, an n-type electrode AuGe/Ni/Au 160 is deposited on the wafer rear surface, and the resultant structure is sintered. The obtained wafer is cut into a size having a resonator length of 300 µm and a chip width of 300 µm, thereby completing a ridge waveguide semiconductor laser (RWG-LD) device.

The RWG-LD device thus formed requires only one or two crystal growth steps, resulting in a large cost reducing effect and mass-production effect. Also, since a "buried layer" which functions as a current inhibiting layer is unnecessary, neither current leak nor inverse junction breakdown occurs in a buried layer. Accordingly, the device is suitable for high-output operations. The device is also suited to high-speed operations because its parasitic capacitance is small.

Unfortunately, this RWG-LD has the problem of a complicated fabrication process, although it has the superior advantages as above. That is, as described above with reference to Fig. 1, the aforementioned RWG-LD is sintered at a high temperature in the step of forming the p-side electrode 158 after the polyimide resin 159 is cured. This may deform the polyimide resin 159. If this resin 159 deforms, a load acts on the ridge portion formed by a semiconductor. In particular, a large stress is produced at each corner of the ridge in the vicinity of the active layer. This sometimes deteriorates the reliability of the device.

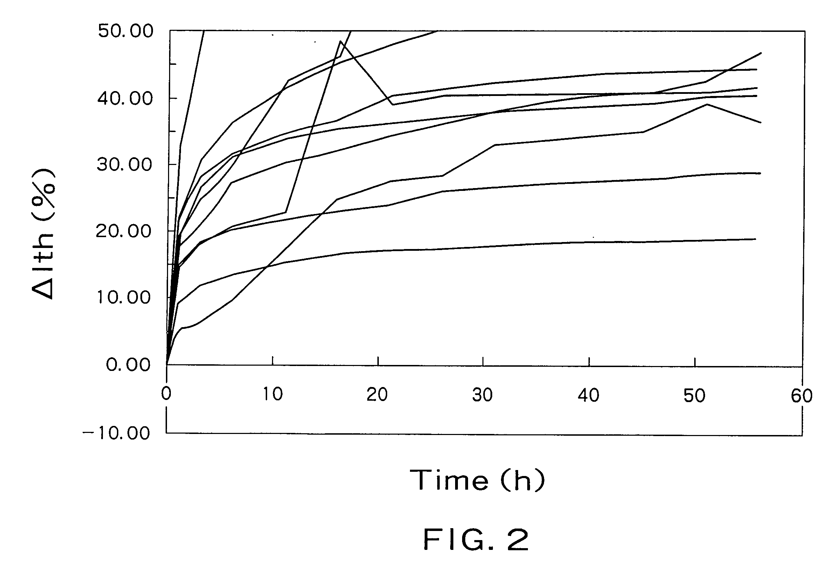

Fig. 2 is a graph showing the results of a reliability test conducted on the above RWG-LD device. That is, Fig. 2 shows a threshold value change rate ΔIₜₕ when a hard burn-in test was conducted under fixed driving conditions of 100°C and 200 mA. As shown in Fig. 2, the threshold current change rate ΔIₜₕ after an elapse of 50 hours (h) was as large as about 40% on the average and kept deteriorating after that.

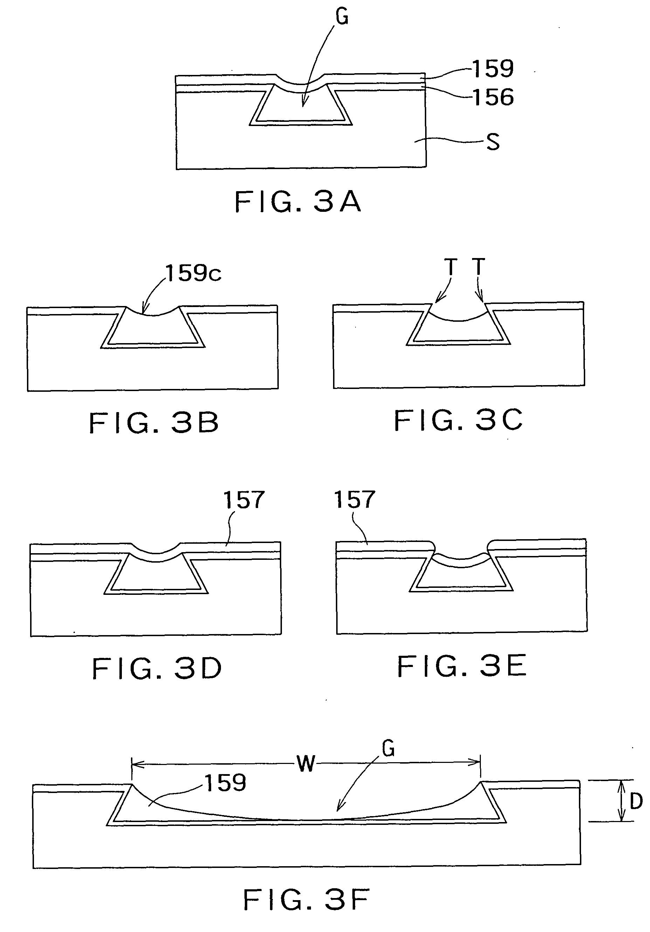

This RWG-LD also has a problem in the steps of burying the resin in the grooves. Figs. 3A to 3F are sectional views showing the steps of burying the resin 159, particularly showing the groove on the side of the ridge in enlarged scale. These steps will be explained below in the order of these drawings. First, as shown in Fig. 3A, an SiO₂ film 156 is formed on a substrate S having a groove G 5 µm wide and 3 µm deep, and coated with a polyimide resin 159.

Next, as shown in Fig. 3B, this polyimide resin is etched by RIE so as to remain only in the groove, thereby exposing the top of the ridge. After that, the resin is cured at 350°C. In this state, a recess 159C is often formed in the center of the groove on the surface of the resin 159 buried in this groove.

Also, "unevenness", i.e., nonuniformity occurs depending on a location in the wafer. Consequently, as shown in Fig. 3C, steps T are sometimes formed on the side walls of the groove in a certain portion. In these steps, as shown in Fig. 3E, an electrode 157 is disconnected in some cases when it is formed at a later time. Fig. 3D shows a structure in which electrode wiring is normally completed.

In this RWG-LD related to the present invention as described above, an electrode may be disconnected depending on a portion in the wafer, and this worsens the yield.

Additionally, the recess 159C in the resin shown in Fig. 3B becomes conspicuous as the width of the groove G increases. Fig. 3F shows the way the resin is buried when a depth D and a width W of the groove G are about 2 µm and about 50 µm, respectively. As shown in Fig. 3F, almost no resin 159 exists in a central portion of the groove G. In a state like this, no electrode bonding pad can be formed on the resin 159. Also, it is impossible to achieve planarization of the wafer as one purpose of the filling of the groove with the resin.

To eliminate these problems, the resin can be again buried in this recess. However, when this method is used the resin must be buried two times or more, and this complicates the fabrication process.

### SUMMARY OF THE INVENTION

A semiconductor optical device according to one aspect of the present invention comprises an active layer formed on a semiconductor substrate, a ridge formed into a mesa shape on the active layer to constrict an electric current supplied to the active layer, and a resin portion for filling a groove around the ridge on the active layer, the resin portion containing benzocyclobutene.

A semiconductor optical device according to another aspect of the present invention comprises an active layer formed on a semiconductor substrate, a cladding layer formed on the active layer, a ridge formed into a mesa shape on the cladding layer to constrict an electric current supplied to the active layer, and a resin portion for filling a groove around the ridge on the cladding layer, the resin portion containing a material selected from the group consisting of benzocyclobutene and polyimide.

A semiconductor optical device according to still another aspect of the present invention comprises a mesa portion formed into a mesa shape on a semiconductor substrate and containing an active layer, and a resin portion for filling a groove around the mesa portion on the semiconductor substrate, the resin portion containing benzocyclobutene.

The active layer is a light emitting portion which emits light in a light emitting device, a light receiving portion which absorbs light to be detected in a light receiving device, and a light modulating portion which changes the intensity or phase of light in an optical modulator.

### BRIEF DESCRIPTION OF THE DRAWINGS

Fig. 1 is a conceptual view showing the structure of a Fabry-Perot RWG-LD related to the present invention;
Fig. 2 is a graph showing the results of a reliability test conducted on the RWG-LD device related to the present invention;
Figs. 3A to 3F are sectional views showing steps of burying a resin 159, particularly showing a groove on the side of a ridge in enlarged scale;
Figs. 4A to 4C are schematic views of a ridge semiconductor laser device of the first embodiment of the present invention, in which Fig. 4A is a plan view of the device, Fig. 4B is a sectional view taken along a line A - A in Fig. 4A, and Fig. 4C is a sectional view showing a modification of this first embodiment;
Figs. 5A, 5B, and 5C are sectional views showing the fabrication steps of the semiconductor laser of the first embodiment;
Figs. 6A, 6B, and 6C are sectional views showing the fabrication steps of the semiconductor laser of the first embodiment;
Fig. 7 is a graph showing the results of a reliability test conducted on the semiconductor laser device of the first embodiment of the present invention;
Figs. 8A and 8B are conceptual views showing the main sections of mesa portions of a "normal mesa" and an "inverted mesa", respectively;
Figs. 9A and 9B are conceptual sectional views showing a buried resin of the semiconductor device in enlarged scale;
Figs. 10A and 10B are views showing the results of quantitative examination on the depth of a recess in the buried resin;
Figs. 11A to 11C are schematic views of a modification of the first embodiment, in which Fig. 11A is a plan view of the modification, Fig. 11B is a sectional view taken along a line A - A in Fig. 11A, and Fig. 11C is a sectional view showing the modification;
Fig. 12 is a sectional view showing the field distribution of light formed in an active layer of the first embodiment;
Fig. 13 is a sectional view showing the field distribution of light formed in an active layer of the modification of the first embodiment;
Figs. 14A and 14B are schematic views of a mesa light emitting diode of the second embodiment of the present invention, in which Fig. 14A is a plan view of the diode, and Fig. 14B is a sectional view showing a central portion and its vicinity of the diode; and
Figs. 15A and 15B are schematic views of a mesa light receiving device of the third embodiment of the present invention, in which Fig. 15A is a plan view of the device, and Fig. 15B is a sectional view showing a central portion and its vicinity of the device.

### DESCRIPTION OF THE PREFERRED EMBODIMENTS

Embodiments of the present invention will be described below with reference to the accompanying drawings.

### (First Embodiment)

As the first embodiment of a semiconductor optical device of the present invention, a ridge semiconductor laser will be explained.

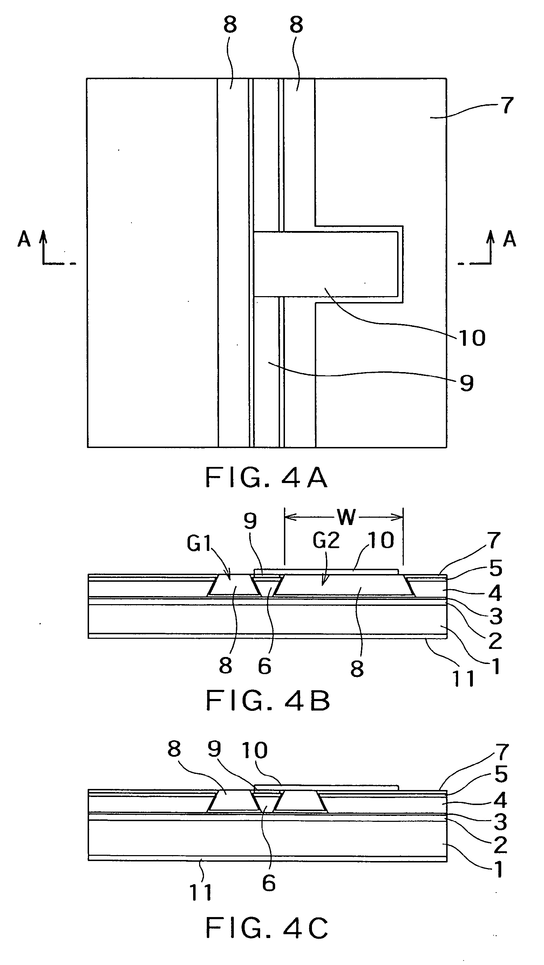

Figs. 4A and 4B are schematic views of the ridge semiconductor laser device of this embodiment. That is, Fig. 4A is a plan view of the device, and Fig. 4B is a sectional view taken along a line A - A in Fig. 4A.

The semiconductor laser of this embodiment has a ridge 6 formed into a mesa. This ridge 6 has a function of constricting light and an electric current into an active layer to be described later. One characteristic feature of the embodiment is that grooves G1 and G2 formed on the two sides of this ridge 6 are filled flat with a resin 8 containing BCB (BenzoCycloButene). In the laser shown in Fig. 4B, a bonding pad 10 is formed on the flat surface of the resin 8 filling the wide groove G2.

In this first embodiment as shown in Fig. 4B, even when a width W of the groove G2 is as large as, e.g., about 50 µm, this groove G2 can be filled flat without forming a recess 159 as shown in Fig. 3F. As a consequence, the bonding pad 10 can be formed on the resin 8 without any disconnection.

Fig. 4C is a sectional view showing a modification of this embodiment. In a laser shown in Fig. 4C, both grooves at the two sides of the ridge 6 are narrow, and the bonding pad 10 extends to the opposite side across the resin 8. Even in this modification, no step is readily formed on the edges of the resin 8. This effectively prevents the disconnection of the bonding pad 10.

To reduce the parasitic capacitance, however, the arrangement shown in Fig. 4B is more advantageous. That is, the parasitic capacitance of the bonding pad portion can be reduced to about 1/5 by thus forming the BCB resin 8 below the bonding pad 10.

In the modification shown in Fig. 4C, the capacitance of the bonding pad portion is primarily determined by the MIS (Metal Insulator Semiconductor) capacitance of a portion overlapping an SiO₂ film 7. Assuming the area of the bonding pad 10 is 50 µm² and the film thickness of the SiO₂ film 7 is 500 nm, the parasitic capacitance is 0.2 pF.

In contrast, when the portion below the bonding pad 10 is filled with the BCB resin 8 as shown in Fig. 4B, the parasitic capacitance of the bonding pad portion is 0.03 pF, approximately one tenth the above value, assuming the area of the bonding pad 10 is 50 µm² and the film thickness of the BCB resin 8 is 2 µm. The BCB resin has a small dielectric constant of 2.65, allows the formation of a thick film, and has the effect of greatly reducing the parasitic capacitance of the pad portion. This effect of reducing the parasitic capacitance is especially notable in an ultra high frequency band in which the modulation frequency is 10 GHz or more. Accordingly, the effect of the filling with the BCB resin 8 is very large.

The steps of fabricating the laser of this embodiment will be described below with reference to the accompanying drawings.

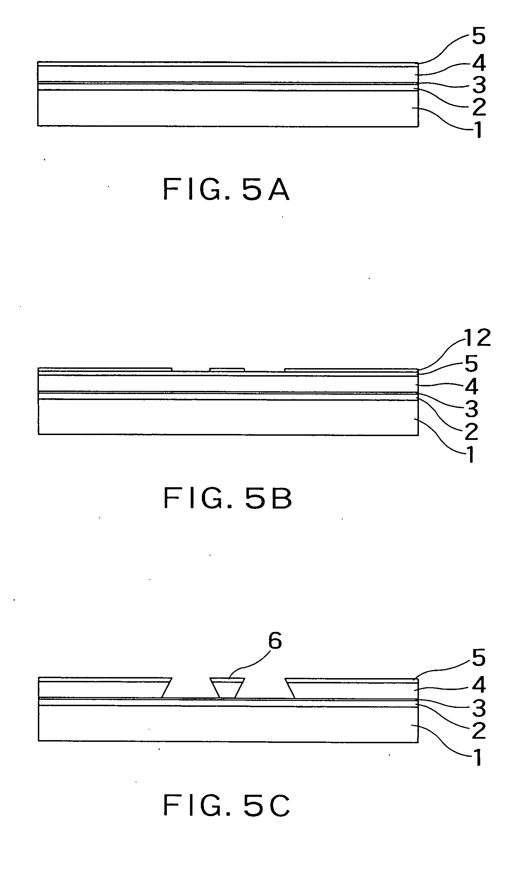

Figs. 5A to 6C are sectional views showing the fabrication steps of the semiconductor laser of this embodiment. Although these drawings illustrate the fabrication of the structure of the modification shown in Fig. 4C, the structure shown in Fig. 4B is also fabricated in the same manner.

First, as shown in Fig. 5A, on an n-type InP substrate 1, an n-type InP cladding layer 2 (thickness 2 µm, S-doped, 1 x 10¹⁸ cm⁻³), a 1.3-µm composition MQW active layer 3, a p-type InP cladding layer 4 (thickness 2 µm, Zn-doped, carrier concentration 1 x 10¹⁸ cm⁻³), and a p-type InGaAs contact layer 5 (thickness 0.3 µm, Zn-doped, carrier concentration 8 x 10¹⁸ cm⁻³) are sequentially formed by crystal growth by MOCVD.

Next, as shown in Fig. 5B, an SiO₂ film 12 is formed on the entire wafer surface and processed by photolithography to form stripe openings.

Subsequently, a mesa 6 is formed by etching as shown in Fig. 5C. That is, the SiO₂ film 12 is used as a mask to etch away the p-type InGaAs contact layer 5 and the p-type InP cladding layer 4 in this order by a sulfuric acid-based etchant and a hydrogen bromide-based etchant. This etching stops immediately above the 1.3-µm composition MQW active layer 3, forming the ridge 6 having an inverted mesa shape, i.e., having a sectional shape which is wider in an upper portion viewed from the substrate.

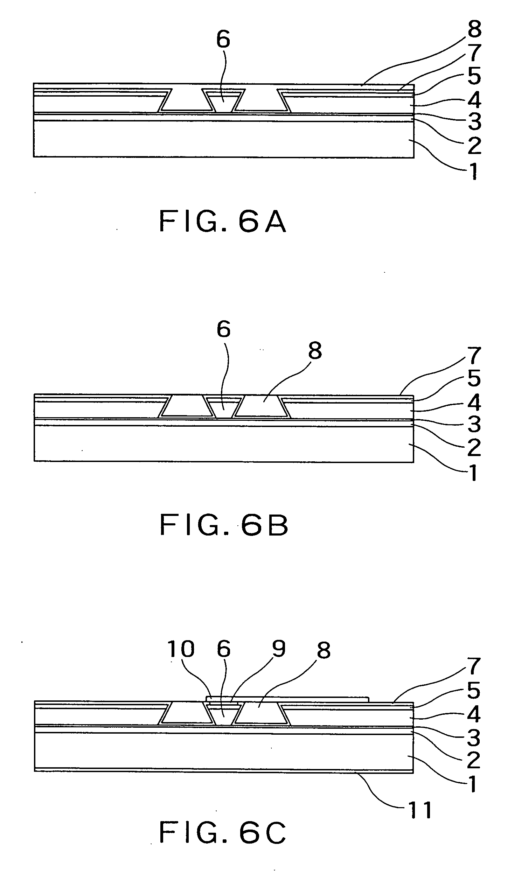

As shown in Fig. 6A, an SiO₂ film 7 is formed on the entire wafer surface by CVD (Chemical Vapor Deposition) and coated with a BCB (BenzoCycloButene) resin 8. This BCB resin 8 is cured at 250°C. An effect of reducing the surface leakage current of a semiconductor can be obtained by forming, e.g., the SiO₂ film 7 as an insulating film before the BCB resin is buried.

Next, as shown in Fig. 6B, the BCB resin 8 is etched from the surface by reactive ion etching (RIB) so as to be buried only in grooves G (the exposure of the top of the ridge). In this step, since the BCB resin 8 has high flatness, no recess 159C is formed unlike when a polyimide resin is applied as shown in Fig. 3F. That is, a flat surface can be obtained by filling the grooves G.

As shown in Fig. 6C, the SiO₂ film 7 on the ridge 6 is etched away so as to remain in the form of a 3-µm wide stripe. Pt (thickness 50 nm) and Ti (thickness 50 nm) are sequentially deposited as a p-side electrode on the entire wafer surface. A p-side electrode 9 is then formed in the SiO₂ stripe opening by liftoff using a resist film (not shown). This resist is removed, and the resultant structure is sintered at 350°C.

Since the optimum sintering temperature of a Pt-based electrode used as the p-side electrode 9 is as low as 350°C, the deformation of the resin 8 can be minimized. Subsequently, a bonding pad 10 made of a Ti/Pt/Au electrode is formed by deposition and liftoff. The n-type InP substrate is polished to a thickness of 100 µm, and an n-side electrode 11 is formed. After that, the wafer is cut into a width of 300 µm and a length of 300 µm, thereby completing the laser device as shown in Fig. 6C.

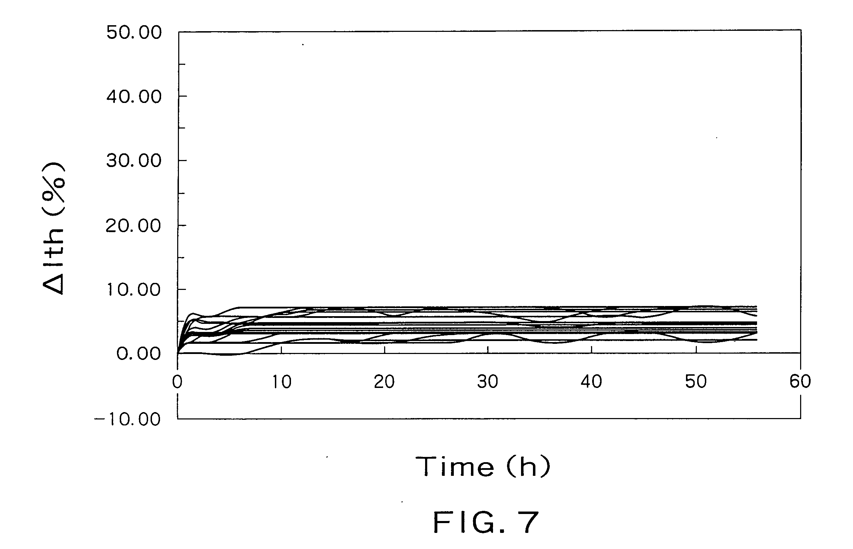

Fig. 7 is a graph showing the results of a reliability test conducted on the semiconductor laser device of this embodiment. That is, Fig. 7 shows a threshold value change rate ΔIₜₕ when a hard burn-in test was conducted under fixed driving conditions of 100°C and 200 mA. As can be seen from Fig. 7, even after an elapse of 50 hours (h) or more, no change was found in the change rate ΔIₜₕ of the threshold current, i.e., almost no deterioration was observed. This proves a large improvement compared to the laser device shown in Fig. 2 in which the polyimide resin is buried.

The reliability of the device is thus greatly improved because, compared to the polyimide resin: (1) the BCB resin has a high humidity resistance and a high weather resistance; (2) the stress that acts on the ridge portion decreases because the deformation by heat is small; and (3) the thermal stress is reduced by lowering the sintering temperature of the p-side electrode 9.

In particular, as to reason (3) described above, the sintering temperature is 450°C when AuZn is used as the p-side electrode of the optical device shown in Fig. 1. In this embodiment, however, good ohmic characteristics are obtained even at a sintering temperature of 350°C by the use of a Pt-based electrode as the p-side electrode. More specifically, the thermal stress loaded onto the ridge portion is lowered by decreasing the sintering temperature of the p-side electrode by about 100°C, thereby lowering the series resistance and improving the reliability of the device.

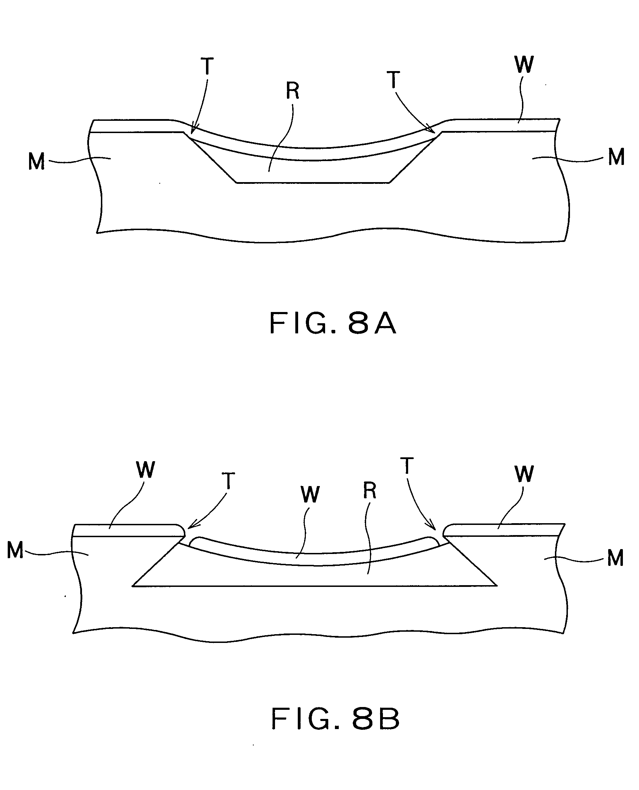

The effect obtained by this embodiment is particularly remarkable when the mesa portion is a so-called "inverted mesa". Figs. 8A and 8B are conceptual views showing the main sections of mesa portions of a "normal mesa" and an "inverted mesa", respectively.

In the normal mesa as depicted in Fig. 8A, even when the flatness of a resin R more or less lowers, steps T on the side walls of a mesa portion M are moderate. So, disconnection of a wiring layer W can be avoided.

When, however, the mesa portion M is an inverted mesa as shown in Fig. 8B, if the flatness of the resin R deteriorates even slightly, steep steps T are formed on the side walls of this mesa portion M. This readily causes disconnection of the wiring layer W. As described previously with reference to Figs. 3A to 3F, the above-mentioned optical device using the polyimide resin has the problem that wiring disconnection readily occurs with respect to this inverted mesa.

In contrast, in this embodiment the surface flatness can be greatly improved by using the BCB resin as the buried resin, compared to the case in which the polyimide resin is used. Consequently, even in the optical device having an "inverted mesa" as shown in Fig. 8B, it is possible to reliably suppress wiring disconnection, improve the fabrication yield of the device, and improve the reliability.

In this embodiment, on the surface of the optical device, it is possible to fill a larger area with a resin than in the optical device using the polyimide resin described earlier. More specifically, this embodiment can fill a groove having a larger area than in the aforementioned optical device using the polyimide resin, without deepening the groove.

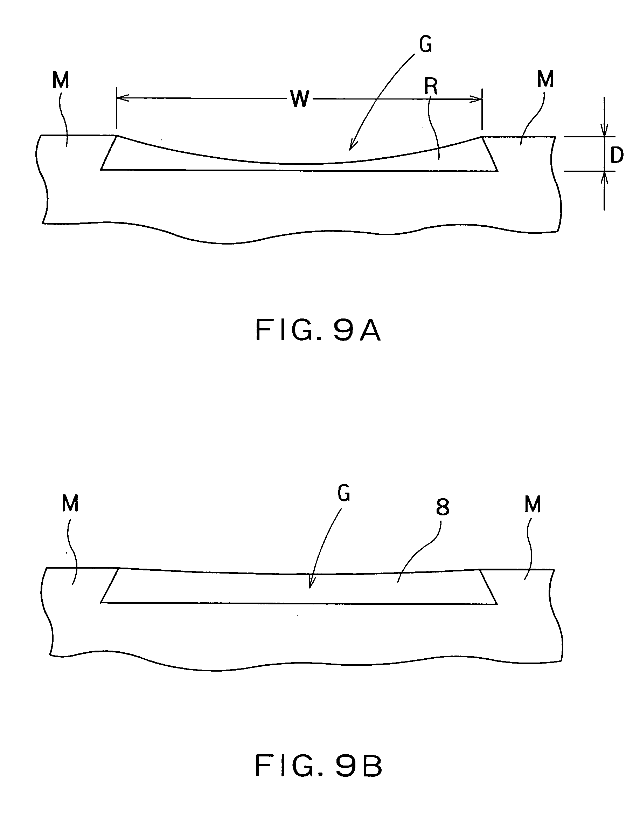

Figs. 9A and 9B are conceptual sectional views each showing, in enlarged scale, the buried resin of the semiconductor optical device. When the polyimide resin R is used, as shown in Fig. 9A, a large recess is formed in this resin R. Hence, "poor step coverage" readily occurs if an electrode layer is formed across the resin R from the mesa M. Also, if the width W of the groove G is increased, the resin in a central portion becomes very thin, so the bottom of the groove is sometimes exposed. If a bonding pad is formed. on this resin, the MIS capacitance undesirably increases.

As will be explained in detail later, the present inventors made extensive studies on trial fabrication. Consequently, when the surface area of the groove G was 900 µm² or more in the ridge laser as shown in Figs. 4A to 4C, the recess in the polyimide resin deepened as shown in Fig. 9A, and poor step coverage of the bonding pad became conspicuous.

By contrast, when the BCB resin 8 is buried by this embodiment, as shown in Fig. 9B, the recess becomes shallow, so the groove G can be filled flat.

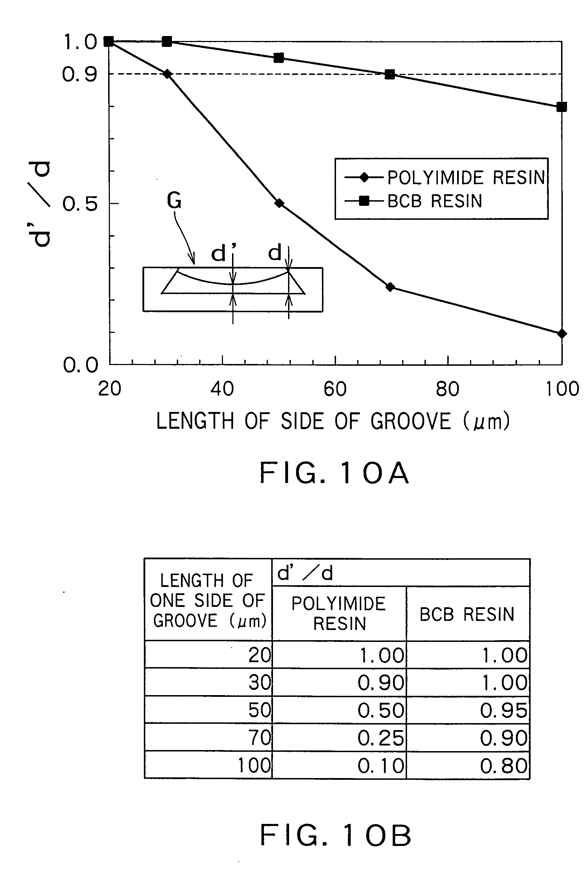

Figs. 10A and 10B are views showing the results of quantitative examination on the depth of the recess in the buried resin. That is, the present inventors filled a groove G having a square opening with the polyimide resin or the BCB resin, and examined a ratio d'/d of a thickness d' of the resin in a central portion to a depth d of the groove G. Note that the depth d of the groove G was 2 µm which is a value normally set in many optical devices.

Fig. 10A is a graph showing the dependence of this thickness ratio d'/d on the length of one side of the groove. Fig. 10B is a table showing similar results.

As apparent from these results, when the polyimide resin is used, the ratio d'/d abruptly lowers and the recess deepens as the length of one side of the groove increases. When the recess thus deepens, poor step coverage readily occurs on the edges if a bonding pad or the like is formed. According to the results of the trial fabrication and examination by the present inventors, when the ratio d'/d was lower than 0.9, poor step coverage of a bonding pad occurred significantly on the edges of the buried resin. That is, when the polyimide resin is used, poor step coverage of a bonding pad formed on the resin easily takes place if the length of one side of the groove exceeds 30 µm.

In contrast, when the BCB resin was used, the ratio d'/d maintained high values and the recess was shallow even if the length of one side of the groove exceeded 30 µm. That is, when the BCB resin is used, the recess does not deepen and no poor step coverage of a bonding pad occurs even if the length of one side of the groove exceeds 30 µm. In other words, even when the area of the groove is as large as 900 µm² or more, the recess is shallow, and poor step coverage of a bonding pad does not occur easily.

In this embodiment as has been described in detail above, it is possible to implement a semiconductor optical device having a groove with a larger area than in the above-mentioned optical device using the polyimide resin. Alternatively, this embodiment can implement a semiconductor optical device having a groove shallower and wider than in the aforesaid optical device using the polyimide resin. This greatly increases the degree of freedom of design.

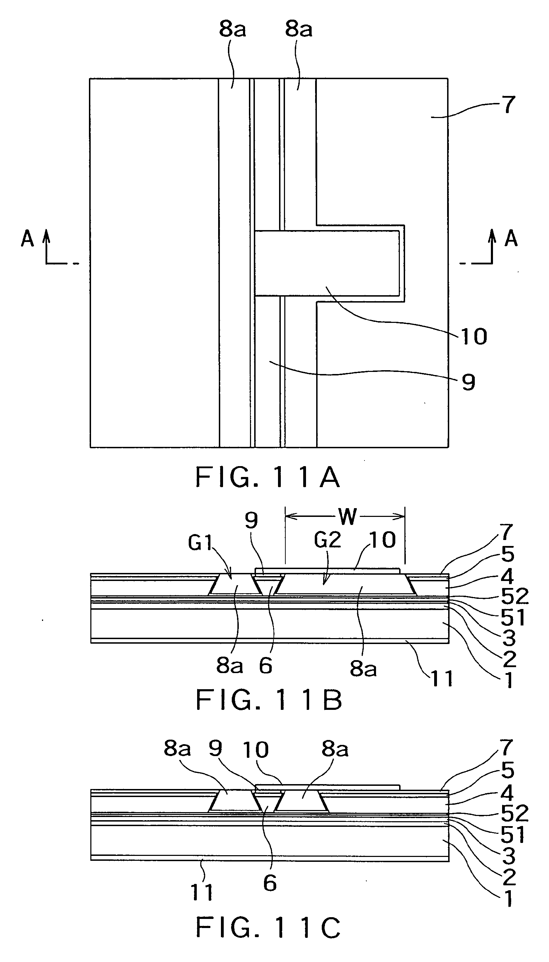

A modification of the above embodiment will be described below with reference to Figs. 11A and 11B showing the arrangement of this modification.

Fig. 11A is a plan view showing a ridge semiconductor laser device of this embodiment. Fig. 11B is a sectional view taken along a line A - A in Fig. 11A.

In the semiconductor laser of this embodiment, different from the first embodiment shown in Figs. 4A to 4C, a p-type InP cladding layer 51 and an InGaAsP layer 52 serving as an etching stopper layer are formed between a ridge 6 and an MQW active layer 3, and between an SiO₂ film 7, which is present on the lower surface of a BCB resin or polyimide resin 8a which fills grooves on the two sides of the ridge 6, and the MQW active layer 3. Also, unlike the first embodiment described above, not only a BCB resin but also a polyimide resin can be used as the resin for filling the grooves on the two sides of the ridge 6. The reason why a polyimide resin can also be used is as follows.

When a polyimide resin is used as the resin 8a for filling the grooves at the two sides of the ridge 6, stress is exerted on the MQW active layer 3 by the resin to allow easier generation of strain than when a BCB resin is used. However, when the InP cladding layer 51 is interposed between the MQW active layer 3 and the resin 8a, this InP cladding layer 51 functions as a buffer layer and reduces the stress applied to the MQW active layer 3 by the resin 8a. This makes it possible to use a polyimide resin as the resin 8a in this modification. However, the use of a BCB resin, not a polyimide resin, as the resin 8a is preferred because the stress can be reduced more.

In this modification having the above arrangement, not only the SiO₂ film 7 but also the InP cladding layer 51 and the InGaAsP layer 52 are interposed between the BCB resin or polyimide resin 8a and the MQW active layer 3. Accordingly, the BCB resin or polyimide resin 8a reduces the stress applied to the MQW active layer 3, so the reliability of the device can be increased.

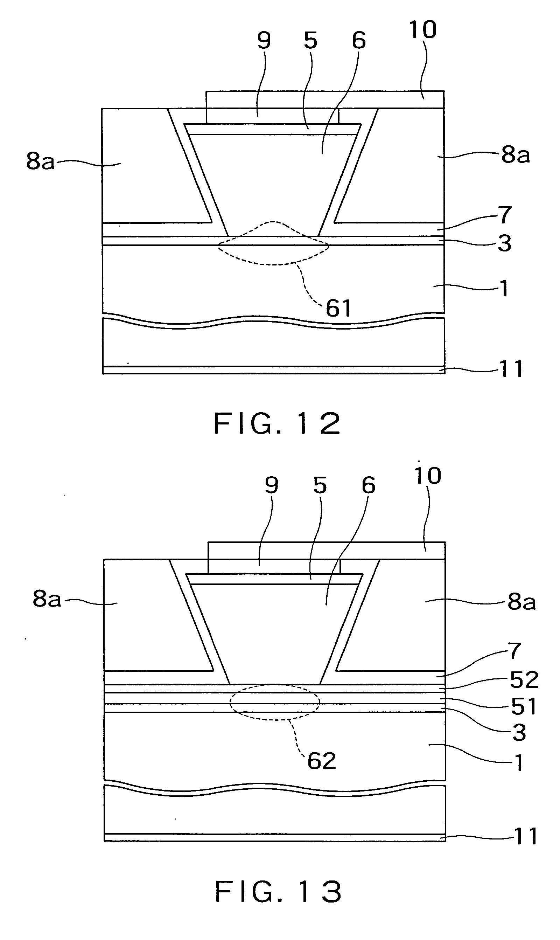

In addition, the BCB resin or polyimide resin 8 has a refractive index smaller than that of a semiconductor material, producing a large refractive index difference between this resin 8 and the MQW active layer 3. In the above first embodiment, therefore, a field distribution indicating the distribution of confined light deforms like a region 61 surrounded by the dotted line in Fig. 12.

In contrast, in this modification the InP cladding layer 51 having a small refractive index difference with respect to the MQW active layer 3 is interposed between this MQW active layer 3 and the BCB resin or polyimide resin 8. Accordingly, a field distribution does not deform as indicated by a region 62 shown in Fig. 13. As a consequence, good light emission characteristics can be obtained.

In this modification, it is desirable to take into account the possibility that an electric current flowing from the ridge 6 toward the MQW active layer 3 leaks in the lateral direction in the InP cladding layer 51 present between the ridge 6 serving as a current constriction layer and the MQW active layer 3.

This leakage current can be suppressed by decreasing the resistance of the InP cladding layer 51 by increasing the carrier concentration in this InP cladding layer 51 to, e.g., 5 x 10¹⁷ cm⁻³. This effect of suppressing the leakage current is particularly enhanced when the carrier concentration in the InP cladding layer 51 immediately below the ridge 6 is increased.

In a modification shown in Fig. 11C, unlike the first modification of this embodiment shown in Fig. 4C, a p-type InP cladding layer 51 and an InGaAsP layer 52 are formed between a ridge 6 and an MQW active layer 3, and between an SiO₂ film 7, which is present on the lower surface of a BCB resin or polyimide resin 8a which fills grooves on the two sides of the ridge 6, and the MQW active layer 3. The rest is the same as the modification shown in Fig. 4C, so a detailed description thereof will be omitted.

### (Second Embodiment)

A mesa light emitting diode will be described below as the second embodiment of the semiconductor optical device of the present invention.

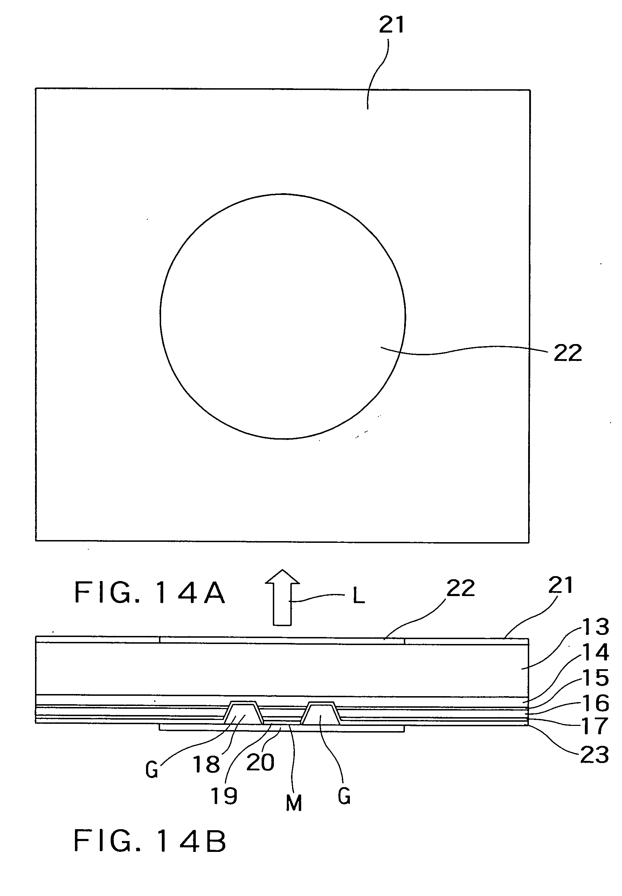

Figs. 14A and 14B are schematic views of the mesa light emitting diode of this embodiment. Fig. 14A is a plan view of the diode, and Fig. 14B is a sectional view of the center and its vicinity of the diode.

That is, the light emitting diode of this embodiment has a structure in which a substantially circular mesa portion M is formed in the center and its vicinity of the device, and a donut-shaped groove G around this mesa portion M is filled with a BCB resin 18. The mesa portion M includes a light emitting portion as an active region, and the emitted light can be extracted in the direction of an arrow L.

In the light emitting diode of this embodiment, a flat planar structure can be obtained by burying the BCB resin 18 in the donut-shaped groove G around the mesa portion M including the active region. Also, a bonding pad 20 can be formed on this flat planar structure without any disconnection. As a consequence, it is possible to largely reduce the parasitic capacitance in the bonding pad portion and perform high-speed modulation.

In addition, compared to a case in which a polyimide resin is buried, it is possible to reduce the stress applied to the mesa portion M and greatly improve the reliability of the device.

The structure of the light emitting diode of this embodiment will be explained below following the procedure of fabrication.

First, on an n-type InP substrate 13, an n-type InP cladding layer 14 (thickness 2 µm, S-doped, 1 x 10¹⁸ cm⁻³), a 1.3-µm composition MQW active layer 15, a p-type InP cladding layer 16 (thickness 2 µm, Zn-doped, carrier concentration 1 x 10¹⁸ cm⁻³), and a p-type InGaAs contact layer 17 (thickness 0.5 µm, Zn-doped, carrier concentration 8 x 10¹⁸ cm⁻³) are sequentially formed by crystal growth by MOCVD.

Next, an SiO₂ film is formed, and the entire wafer surface is coated with a photoresist. The SiO₂ film is then partly etched away into the shape of a donut having an inner diameter of 20 µm and an outer diameter of 30 µm.

Subsequently, the p-type InGaAs contact layer 17, the p-type InP cladding layer 16, the 1.3-µm composition MQW active layer 15, and the n-type InP cladding layer 14 are etched with a hydrogen bromide-based etchant, thereby forming a substantially circular mesa.

An SiO₂ film 23 is formed on the entire wafer surface by CVD and coated with a BCB (BenzoCycloButene) resin 18. After this BCB resin 18 is cured at 250°C, the top of the mesa portion M is exposed by reactive ion etching (RIE). Since the BCB resin has high flatness, the groove can be filled flat without forming any recess unlike when a polyimide resin is applied.

After that, a circular window 15 µm in diameter is formed on the mesa. Pt (thickness 50 nm) and Ti (thickness 50 nm) are sequentially deposited as a p-type electrode on the entire wafer surface. A p-type electrode 19 is then formed into the shape of a stripe in the window by liftoff using a resist film (not shown).

This resist film is removed, and the resultant structure is sintered at 350°C. Since the optimum sintering temperature of a Pt-based electrode is as low as 350°C, the deformation of the resin 18 can be minimized. Subsequently, a bonding pad 20 made of a Ti/Pt/Au electrode is formed by deposition and liftoff.

The n-type InP substrate 13 is polished to a thickness of 100 µm, and an n-side electrode 21 is formed. At the same time, a window 22 for extracting light is formed, and in this window a 0.2-µm thick Si₃N₄ film is formed as an antireflection film. After that, the wafer is cut into a width of 300 µm and a length of 300 µm to complete the light emitting diode.

### (Third Embodiment)

A mesa light receiving device will be described below as the third embodiment of the semiconductor optical device of the present invention.

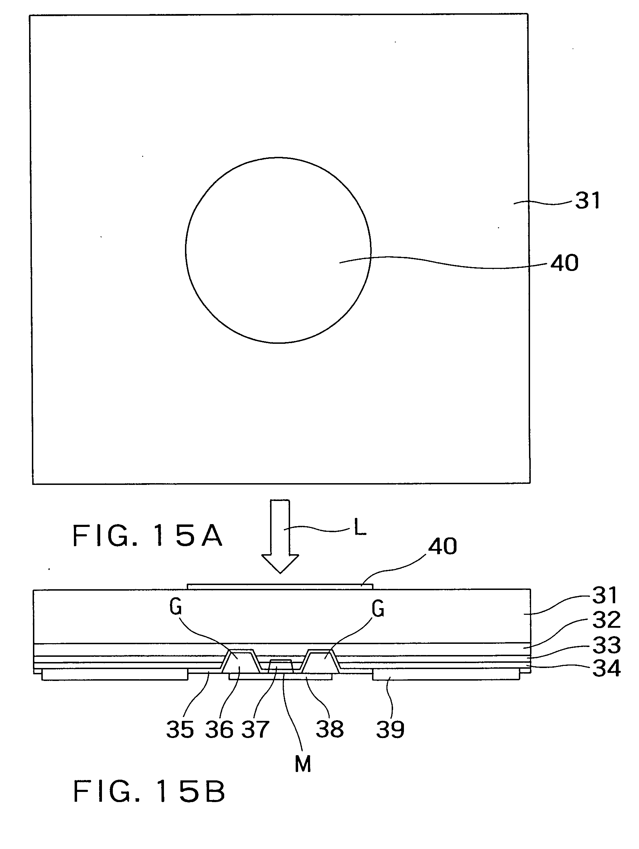

Figs. 15A and 15B are schematic views of the mesa light receiving device of this embodiment. Fig. 15A is a plan view of the device, and Fig. 15B is a sectional view of the center and its vicinity of the device.

In the light receiving device of this embodiment, a substantially circular mesa portion M is formed in the center and its vicinity of the device, and a donut-shaped groove G around this mesa portion M is filled with a BCB resin 36. In the mesa portion M, a p-type diffusion region 37 is formed, and a light receiving region is formed as an active region. Light is incident on this light receiving region in the direction of an arrow L and detected.

In this embodiment, various effects similar to those of the first and second embodiments can be obtained by burying the BCB resin 36 to form a planar structure.

The structure of the light receiving device of this embodiment will be explained below following the procedure of fabrication.

First, on an n-type InP substrate 31, an n-type InP buffer layer 32 (thickness 3 µm, S-doped, 1 x 10¹⁸ cm⁻³), an InGaAs light absorbing layer 33, and an n-type InP window layer 34 (thickness 2 µm, carrier concentration 1 x 10¹⁵ cm⁻³) are sequentially formed by crystal growth by VG (Epitaxial Vapor Growth).

Next, in the center and its vicinity of the device, Zn (zinc) is selectively diffused to reach the InGaAs light absorbing-layer 33, thereby forming a p-type diffusion region 37.

Subsequently, an SiO₂ film is formed, and the entire wafer surface is coated with a photoresist. The SiO₂ film is then partly etched away by photolithography into the shape of a donut having an inner diameter of 40 µm and an outer diameter of 50 µm. The resultant structure is etched with a hydrogen bromide-based etchant until the n-type InP buffer layer 32 is exposed, thereby forming a mesa portion M.

An Si₃N₄ film 35 is formed on the entire wafer surface by p-type CVD and coated with a BCB (BenzoCycloButene) resin. After this BCB resin is cured at 250°C, the top of the mesa portion M is exposed by reactive ion etching (RIE). Since the BCB resin 36 has high flatness, the groove can be filled flat without forming any recess unlike when a polyimide resin is applied.

After that, a ring window 10 µm wide is formed on the mesa portion M. Pt (thickness 50 nm), Ti (thickness 50 nm), and Au (thickness 1 µm) are sequentially deposited as a p-type electrode 38 and an n-type electrode 39 on the entire wafer surface. These electrodes are then processed by liftoff using a resist film (not shown).

This resist film is removed, and the resultant structure is sintered at 350°C. Since the optimum sintering temperature of a Pt-based electrode is as low as 350°C, the deformation of the resin can be minimized. Subsequently, the n-type InP substrate 31 is polished to a thickness of 100 µm, and a 0.2-µm thick Si₃N₄ film 40 is formed as an antireflection film on the light incident surface. After that, the wafer is cut into a width of 300 µm and a length of 300 µm to complete the light receiving device.

This embodiment makes it possible to implement a light receiving device capable of high-speed operations and having high reliability, by reducing the parasitic capacitance in the bonding pad portion.

The forms of practice of the present invention have been explained above by taking practical embodiments as examples. However, the present invention is not limited to these embodiments. For example, the present invention is similarly applicable to an optical modulator as well as to a light emitting device and a light receiving device.

More specifically, an electro-absorption modulator (EAM) can be fabricated by applying a structure analogous to that of the ridge laser presented as the first embodiment. This modulator can change the light absorbance of a light modulating portion as an active region by changing the voltage applied to the upper and lower electrodes 10 and 11 shown in Figs. 4A to 4C. In this manner, the intensity of light guided in this light modulating portion can be modulated. The above-mentioned effects can be obtained by this modulator by filling the two sides of the ridge with a BCB resin.

Also, a light emitting device or a light receiving device is not restricted to the form shown in Figs. 14A and 14B or Figs. 15A or 15B. For example, the present invention is similarly applicable to a so-called "waveguide light emitting device" or "waveguide light receiving device" having a ridge waveguide. That is, the aforesaid various effects can be obtained by filling the two sides of the ridge waveguide with a BCB resin.

In addition, the materials of these light emitting device, light receiving device, and optical modulator are not limited to InP-based materials. That is, the present invention can be applied to diverse group III-V compound semiconductors such as GaAs-, GaP-, and GaN-based compound semiconductors, or to group II-VI compound semiconductors such as ZnSe and CdTe.

Furthermore, similar effects can be obtained by applying the present invention to, e.g., an integrated optical device fabricated by appropriately combining a light emitting device, light receiving device, and optical modulator.

## Claims

1. A semiconductor optical device comprising:
an active layer formed on a semiconductor substrate;
a ridge formed into a mesa shape on said active layer to constrict an electric current supplied to said active layer; and
a resin portion for filling a groove around said ridge on said active layer, said resin portion containing benzocyclobutene.

2. A device according to claim 1, wherein
said semiconductor substrate contains an n-type semiconductor material, said semiconductor optical device further comprising an n-side electrode formed on said semiconductor substrate,
said ridge contains a p-type semiconductor material, said semiconductor optical device further comprising a p-side electrode formed on said ridge, and
said p-side electrode comprises a platinum (Pt) layer formed on said ridge and a titanium (Ti) layer stacked on said platinum layer.

3. A device according to claim 2, wherein said ridge has a mesa shape smaller in area on an active layer side than on a p-side electrode side.

4. A device according to any of claims 1 to 3, further comprising a metal layer continuously formed on said ridge and said resin portion.

5. A device according to any of claims 1 to 4, further comprising an insulating film formed between inner wall surfaces of said groove and said resin portion.

6. A device according to any of claims 1 to 5, wherein on a side at which said ridge is formed, an area accounted for by said groove filled with said resin portion is not less than 900 µm².

7. A semiconductor optical device comprising:
an active layer formed on a semiconductor substrate;
a cladding layer formed on said active layer;
a ridge formed into a mesa shape on said cladding layer to constrict an electric current supplied to said active layer; and
a resin portion for filling a groove around said ridge on said cladding layer, said resin portion containing a material selected from the group consisting of benzocyclobutene and polyimide.

8. A device according to claim 7, wherein
said semiconductor substrate contains an n-type semiconductor material, said semiconductor optical device further comprising an n-side electrode formed on said semiconductor substrate,
said ridge contains a p-type semiconductor material, said semiconductor optical device further comprising a p-side electrode formed on said ridge, and
said p-side electrode comprises a platinum (Pt) layer formed on said ridge and a titanium (Ti) layer stacked on said platinum layer.

9. A device according to claim 8, wherein said ridge has a mesa shape smaller in area on an active layer side than on a p-side electrode side.

10. A device according to any of claims 7 to 9, further comprising a metal layer continuously formed on said ridge and said resin portion.

11. A device according to any of claims 7 to 10, further comprising an insulating film formed between inner wall surfaces of said groove and said resin portion.

12. A device according to any of claims 7 to 11, wherein on a side at which said ridge is formed, an area accounted for by said groove filled with said resin portion is not less than 900 µm².

13. A semiconductor optical device comprising:
a mesa portion formed into a mesa shape on a semiconductor substrate and containing an active layer; and
a resin portion for filling a groove around said mesa portion on said semiconductor substrate, said resin portion containing benzocyclobutene.

14. A device according to claim 13, wherein
said semiconductor substrate contains an n-type semiconductor material, said semiconductor optical device further comprising an n-side electrode formed on said semiconductor substrate,
said mesa portion contains a p-type semiconductor material, said semiconductor optical device further comprising a p-side electrode formed on said mesa portion, and
said p-side electrode comprises a platinum (Pt) layer formed on said mesa portion and a titanium (Ti) layer stacked on said platinum layer.

15. A device according to claim 13 or 14, wherein said mesa portion has a mesa shape smaller in area on a side farther from said semiconductor substrate than on a side closer to said semiconductor substrate.

16. A device according to any of claims 13 to 15, further comprising a metal layer continuously formed on said mesa portion and said resin portion.

17. A device according to any of claims 13 to 16, further comprising an insulating film formed between inner wall surfaces of said groove and said resin portion.

18. A device according to any of claims 13 to 17, wherein on a side at which said mesa portion is formed, an area accounted for by said groove filled with said resin portion is not less than 900 µm².
